# EUROPEAN PATENT APPLICATION

(11) **EP 0 782 263 A1**
(43) Date of publication of application: **02.07.1997**
(21) Application number: 96119689.6
(22) Date of filing: 09.12.1996
(51) Int. Cl.: H03K 5/08

(54) **Edge detector with hysteresis**

(30) Priority: 26.12.1995 US 578725
(71) Applicant: MOTOROLA, INC., Schaumburg, IL 60196 (US)
(72) Inventor: Shook, Stephen G., Gilbert, Arizona 85233 (US); Schwartz, Daniel B., Apache Junction, Arizona 85219 (US); Chun, Christopher K.V., Gilbert, Arizona 85233 (US)
(74) Representative: Hudson, Peter David

(57) **Abstract**

An edge-detecting signal processing circuit (10) establishes upper guardband (19) and lower guardband (26) limits that are used to determine when an input signal (14) transitions from one state to another. The input signal is sampled and the upper or lower limit of the signal is stored. The stored value (18) is used to set the guardband limits. The input signal is compared to the upper and lower guardband limits and an out-of-guardband signal (31) is formed. The out-of-guardband signal is used to control forming an output signal (38) and in changing the stored value (18) of the input signal.

## Description

### Background of the Invention

The present invention relates, in general, to communication systems, and more particularly, to signal processing circuits for communication systems.

In the past, a variety of design approaches have been utilized to implement signal processing circuits for communication systems, such as receivers for optical communication systems. Several methods are used for receiver designs in such systems including differential, adaptive feedback, fixed threshold, and edge detection methods.

One problem with the adaptive feedback receivers is the operation during idle time of the burst-mode communication signal applied to the receiver. Such circuits typically utilize differential amplifiers and have feedback loops in order to implement automatic gain control and automatic offset control within the receivers. During idle time, the feedback loop decreases threshold voltage applied to the differential amplifiers thereby causing the receiver to output noise. Additionally, the peak and minimum input voltage values drift over time causing pulse width distortion or even erroneous signals in the output from the receivers.

Fixed threshold schemes typically require a large dynamic range which results in pulse width distortion. Differential and edge detection schemes are edge rate dependent and also result in pulse width distortion.

Accordingly, it is desirable to have a signal processing circuit that does not oscillate, that does not utilize feedback, and that minimizes pulse width distortion in the output signal.

### Brief Description of the Drawings

FIG. 1 schematically illustrates an edge-detecting signal processing circuit in accordance with the present invention;
FIG. 2 is a timing diagram illustrating the operation of a portion of the circuit illustrated in FIG. 1 in accordance with the present invention;
FIG. 3 schematically illustrates a portion of the circuit of FIG. 1 in accordance with the present invention; and
FIG. 4 schematically illustrates another portion of the circuit of FIG. 1 in accordance with the present invention.

### Detailed Description of the Drawings

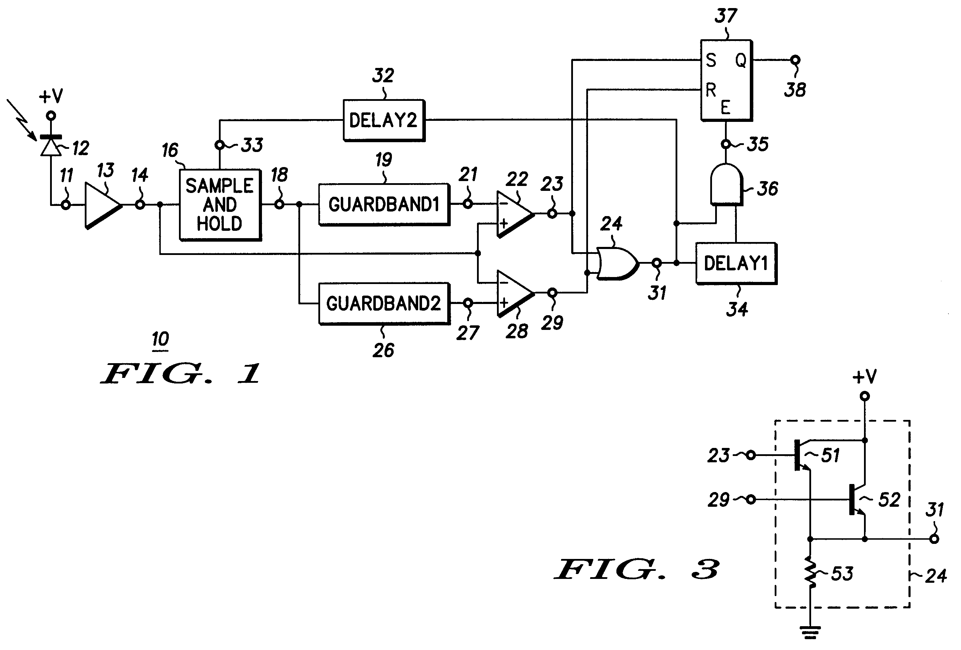

FIG. 1 schematically illustrates an edge-detecting signal processing circuit 10 that is suitable for receiving burst-mode signals and that minimizes pulse-width distortion. Circuit 10 includes a received data input 11 that is suitable for accepting a received signal, such as the signal from a photodetector 12 that detects light received by a fiber optic communication system. The received signal on input 11 is applied to an input of a preamplifier 13 which amplifies the received signal and forms an input signal on an output of preamplifier 13. The input signal is applied to a signal input 14 of circuit 10. As will be seen hereinafter, circuit 10 produces two guardband signals that are used to form an upper and lower limit around the input signal value. The upper and lower limits facilitate determining when the input signal on input 14 transitions from one state to another state. That is, circuit 10 establishes guardband limits around the upper value and the lower value of the input signal. When the input signal transitions from one state to a new state, circuit 10 forms an output signal that corresponds to the new state of the input signal after the input signal value becomes either greater than the upper value or less than the lower value while changing to the new state.

Circuit 10 includes a sample-and-hold circuit 16 that receives the input signal and stores a value of the input signal on a storage element that is a part of circuit 16. This function is typically referred to as sampling the input signal and holding the value of the input signal on the storage element, or a sample-and-hold function. As will be seen hereinafter, circuit 10 stores either an upper value or a lower value of the input signal. A reset signal is applied to a reset input 33 of circuit 16 in order to change the stored value of the input signal from the upper value to the lower value as will be seen hereinafter. The stored value of the input signal is applied to an output 18 of circuit 16.

A first or upper guardband circuit 19 receives the stored value of the input signal from output 18 and produces an upper guardband signal on an output 21. The upper guardband signal is greater than the stored value of the input signal and is used to determine when the input signal amplitude has increased to a value that requires resetting circuit 16 in order to change the stored value of the input signal from the lower limit to the upper limit. The differential between the stored value of the input signal and the upper guardband signal typically is chosen to be a multiple of the signal noise value on the input signal applied to input 14. That is, the upper guardband signal is greater than the stored value of the input signal by an amount that is a multiple of the noise anticipated on the input signal. This differential value differs based on the system environment in which signal processing circuit 10 is used. In the preferred embodiment, the multiple is at five least times the expected noise value. A second or lower guardband circuit 26 receives the stored value from output 18 and generates a lower guardband signal on an output 27. The lower guardband signal is less than the stored value of the input signal and is used to determine when the input signal amplitude has decreased to a value that requires resetting circuit 16 in order to change the stored value of the input signal from the upper limit to the lower limit. The differential between the stored value of the input signal and the guardband signal typically is chosen to be a multiple of the signal noise value on the input signal applied to input 14. That is, the lower guardband signal is less than the stored value of the input signal by an amount that is a multiple of the noise anticipated on the input signal. This differential value differs based on the system environment in which a signal process in circuit 10 is used. In the preferred embodiment, the multiple is at least five times the expected noise value. Circuits 19 and 26 can have a variety of circuit implementations including a resistive summation network or a resistive voltage divider.

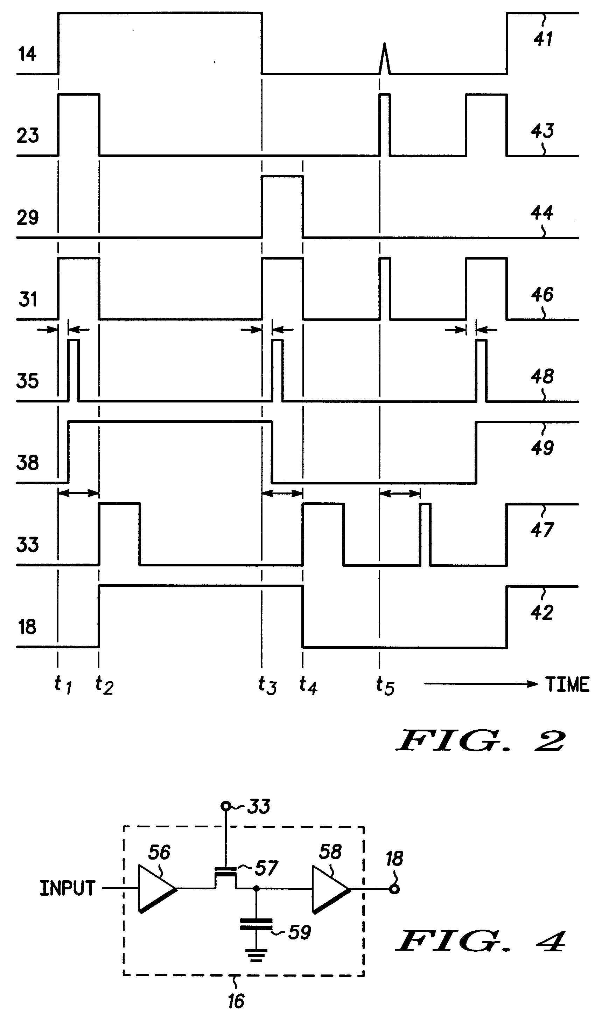

The upper guardband signal on output 21 is applied to a negative input of an upper comparator 22 while the input signal from input 14 is applied to a positive input of comparator 22. Thus, comparator 22 compares the input signal to the upper guardband signal. Comparator 22 produces a below upper guardband signal on an output 23. The below upper guardband signal is inactive or low as long as the input signal is not greater than the value of the upper guardband signal, as will be seen hereinafter in the discussion of FIG. 2. The lower guardband signal on output 27 is applied to a positive input of a lower comparator 28 while the input signal from input 14 is applied to a negative input of comparator 28. Thus, comparator 28 compares the input signal to the lower guardband signal. Comparator 28 produces a below lower guardband signal on an output 29. The below lower guardband signal is inactive or low as long as the input signal is greater than the lower guardband signal.

Output 23 is connected to a set input of an output storage element 37 and output 29 is connected to a reset input of element 37. Outputs 23 and 29 are utilized to set and reset, respectively, the state of element 37 in order to form an output signal on output 38. The above upper guardband signal and the below lower guardband signal are also applied to inputs of an out-of-guardband detection circuit 24. Circuit 24 functions as a digital "OR" gate that detects when either the above upper guardband or below lower guardband signals become active. Consequently, circuit 24 has a first input connected to output 23 and a second input connected to output 29. Circuit 24 produces an out-of-guardband signal on an output 31. The out-of-guardband signal is inactive or low as long as both the above upper guardband and below lower guardband signals are both low. The out-of-guardband signal becomes active or high when either the above upper guardband or below lower guardband signals become high, as will be seen hereinafter.

Out-of-guardband output 31 is connected to inputs of a delay1 circuit 34, an "AND" gate 36, and a delay2 circuit 32. Circuit 34 receives the out-of-guardband signal and delays applying the signal to one input of gate 36. Circuit 34 and "AND" gate 36 produce an output when the input signal has a width that is greater than the delay used for circuit 34. This assists in ensuring that circuit 10 substantially does not produce an output when noise appears on the input signal. The delay used for circuit 34 is greater than the length of time a noise signal is anticipated to exist on the input signal applied to input 14. As a result, the output of gate 36 remains inactive or low as long as the out-of-guardband signal is low. When the out-of-guardband signal becomes active or high, the output of gate 36 remains low until the out-of-guardband signal has been high for a time period at least equal to the delay time utilized by circuit 34. Thereafter, the output of gate 36 remains active for the remaining time that the out-of-guardband signal is active. The output of gate 36 is connected to an enable input of output storage element 37. Element 37 cannot change states until the enable signal is active or high. Thus, the output signal on output 38 cannot change states until the out-of-guardband signal has been active for a time greater than the delay utilized by circuit 34. As will be seen hereinafter, this prevents circuit 10 from responding to noise that exists on input 14 for a time less than the time utilized by delay circuit 34.

Out-of-guardband output 31 is also connected to an input of delay2 circuit 32. Circuit 32 delays the out-of-guardband signal by an amount that is greater than the time utilized by circuit 34. The output of circuit 32 is connected to reset input 33 of circuit 16 and is utilized to change the stored value of the input signal that is applied to output 18. Ensuring that delay2 is longer than delay1, ensures that output 38 accurately reflects the state of the input signal on input 14 before the stored value of the input signal is changed to the new value of the input signal.

FIG. 2 is a timing diagram illustrating the operation of a portion of the signal processing circuit illustrated in FIG. 1. Elements of FIG. 2 that have the same reference numbers as FIG. 1, refer to the corresponding FIG. 1 elements. The input signal on input 14 (FIG. 1) is illustrated by a waveform 41. A waveform 42 illustrates the stored value of the input signal on output 18, a waveform 43 illustrates the above upper guardband signal on output 23, a waveform 44 illustrates the below lower guardband signal on output 29, a waveform 46 illustrates the out of guardband signal on output 31, a waveform 47 illustrates the reset signal on input 33, a waveform 48 illustrates the enable signal on input 35, and a waveform 49 illustrates the output signal on output 38.

At time t₁, input 14 transitions from a lower value to an upper value. This causes above upper guardband output 23 (waveform 43) to become active which causes out-of-guardband output 31 (waveform 46) to also become active. After the delay1 time, input 35 (waveform 48) goes high which enables element 37 allowing the high on output 23 to set output 38 (waveform 49). After the delay2 time, reset input 33 (waveform 47) becomes active which causes circuit 16 to acquire a new stored value so that output 18 (waveform 42) becomes the new value of input 14. As a consequence, output 18 is no longer greater than the upper guardband so output 23 (waveform 43) becomes inactive at time t₂ causing out-of-guardband output 31 (waveform 46) to become inactive. After the delay2 time, reset input 33 follows output 31 and becomes inactive.

At time t₃, the input signal on input 14 (waveform 41) transitions from the upper value to a lower value. When the value of the input signal becomes less than the lower guardband signal on output 27 (FIG. 1), the below lower guardband output 29 (waveform 44) becomes active causing the out-of-guardband output 31 (waveform 46) to also become active. After the delay1 time, enable input 35 (waveform 48) becomes active thereby allowing the below lower guardband signal (waveform 44) to reset the output signal on output 38. After the delay2 time, reset input 33 (waveform 47) becomes active thereby causing output 18 (waveform 42) to store the new input signal value as shown at time t₄.

At time t₅, a noise signal appears on input 14. As the noise signal value becomes greater than the above guardband signal, above upper guardband output 23 (waveform 43) becomes active causing out-of-guardband output 31 to become active. Because the delay1 time is greater than the time that the noise signal appears at input 14, enable input 35 (waveform 48) remains low and does become not active in response to the out-of-guardband signal on output 31 (waveform 46). Consequently, the delay1 circuit substantially prevents noise from causing changes in the output of circuit 10 in response to noise. After the delay2 time, reset input 33 (waveform 47) becomes active causing circuit 16 to store a new value on output 18. However, because this occurs while input 14 is unchanged, the stored value on output 18 (waveform 42) remains unchanged.

As shown by the waveforms in FIG. 2, setting upper and lower guardband limits around the value of the input signal allows detecting input signal transitions from one state to another. As the input signal increases value, the upper guardband signal facilitates detecting the transition, and as the input signal transitions to a lower value the lower guardband signal facilitates detecting the change. Utilizing a delay after an input signal transition and before changing the output facilitates ensuring that circuit 10 does not respond to noise on the input signal.

FIG. 3 schematically illustrates a circuit embodiment for portions of circuit 10 shown in FIG. 1. Elements of FIG. 2 that have the same reference numbers as FIG. 1 are the same as the corresponding FIG. 1 elements. Although described hereinafter in terms of voltage, it should be noted that the received signal, input signal, upper guardband signal, lower guardband signal, above upper guardband signal, below lower guardband signal, and out-of-guardband signal could all be either voltage or current. Thus, preamplifier 13, sample-and-hold circuit 16, upper guardband circuit 19, lower guardband circuit 26, upper comparator 22, lower comparator 28, and out-of-guardband detection circuit 24 could be either voltage, current, transimpedance, or transconductance circuits.

Out-of-guardband detection circuit 24 is formed as a multiple emitter follower circuit that has a first transistor 51 parallel connected to a second transistor 52. Transistors 51 and 52 both have a collector connected to the positive supply terminal and an emitter connected to an emitter follower resistor 53. The base of transistor 51 receives the above guardband on output 23 while the base of transistor 52 receives the below guardband signal on output 29. When the value of the above guardband drops below the value of the below guardband signal, transistor 52 clamps the value applied to output 31 to the value of the below guardband signal minus the V_{BE} drop of transistor 52. When the value of the above guardband is larger than the below guardband signal, transistor 51 pulls the value of the below guardband signal on output 31 to the larger value of the above guardband signal minus the V_{BE} drop of transistor 52. Consequently, the transition signal is always the larger of the above guardband signal or the below guardband signal, minus a V_{BE} drop.

FIG. 4 schematically illustrates an embodiment of a sample and hold circuit that is suitable for use as circuit 16 shown in FIG. 1. Elements of FIG. 4 that have the same reference numbers as FIG. 1 are the same as the corresponding FIG. 1 elements. FIG. 4 illustrates an example of one embodiment that can be used for circuit 16 even though many other implementations are possible. Circuit 16 includes an input buffer 56 that isolates circuit 16 from input 14. A switch 57 is used to couple the output of buffer 56 to a storage element 59 when the reset signal is applied to circuit 16. An output buffer 58 isolates storage element 17 from circuitry connected to output 18. Typically, storage element 59 is a capacitor as illustrated in FIG. 4.

By now, it should be appreciated that there has been provided a novel signal processing circuit and method. Utilizing upper and lower guardband limits around a value of the input signal facilitates detecting when the signal transitions from one state to another. Detecting separate upper and lower transitions allows controlling the absolute state of the output to match the state of the input signal. Delaying changing the output for a time greater than the time noise is anticipated on the input signal assists in ensures that the circuit does not respond to noise. Delaying resetting the stored value of the input signal assists in ensuring that the output is set to the new input signal state before changing the stored value of the input signal. Consequently, the circuit does not cause oscillations when the input signal is idle such as during idle time of burst-mode signals. Also the circuit detects both upper and lower transitions and substantially does not produce pulse-width distortion.

## Claims

1. An edge-detecting signal processing method comprising:
receiving an input signal having an upper value and a lower value;
establishing guardband limits around the upper value and the lower value; and
forming an output corresponding to the input signal after the input signal transitions outside the guardband limits.

2. The method of claim 1 wherein establishing guardband limits includes storing one of the upper value or the lower value on a storage element (16) to form a stored value of the input signal, and using the stored value to form the guardband limits.

3. The method of claim 2 wherein using the stored value to form the guardband limits includes forming an upper guardband by that is greater than the stored value and a lower guardband that is less than the stored value.

4. The method of claim 1 wherein forming the output corresponding to the input signal includes detecting input transitions outside the guardband limits, delaying a delay time after the input transition, and forming the output corresponding to the input signal after the delay time wherein the input signal remains after the delay time.

5. An edge-detecting signal processing method comprising:
storing a first value of an input signal on a storage element (16) as a first stored value;
generating a first lower guardband signal that is less than the first stored value;
generating a first upper guardband signal that is greater than the first stored value;
forming a first output signal after generating the first upper and lower guardband signals; and
changing the first stored value to a second stored value of the input signal after the input signal is one of greater than the first upper guardband signal or less than the first lower guardband signal.

6. The method of claim 5 further including storing the second stored value of the input signal on the storage element (16), generating a second lower guardband signal that is less than the second stored value, generating a second upper guardband signal that is greater than the second stored value, and changing the second stored value to a third stored value of the input signal after the input signal is one of greater than the second upper guardband signal or less than the second lower guardband signal.

7. The method of claim 5 wherein holding the first value of the input signal includes sampling the input signal and storing the first value on the storage element (16).

8. The method of claim 5 wherein changing the first stored value to the second stored value of the input signal after the input signal is one of greater than the first upper guardband signal or less than the first lower guardband signal includes detecting the input signal has a value that is one of greater than the first upper guardband signal and setting an output to an active state or less than the first lower guardband signal and setting the output to an inactive state.

9. A signal processing method comprising:
sampling an input signal and storing a first maximum value of the input signal on a storage element;
generating a guardband signal that is less than the first maximum value of the input signal;
comparing the guardband signal to the input signal; and
sampling the input signal and storing a second maximum value of the input signal that is different from the first maximum value of the input signal wherein the second maximum value of the input signal is stored on the storage element when the input signal is less than the guardband signal.

10. The method of claim 9 further including generating a threshold signal that is a percent of the first maximum value of the input signal, and comparing the input signal to the threshold signal for generating an output signal.
